# EUROPEAN PATENT APPLICATION

(11) **EP 0 801 416 A1**
(43) Date of publication of application: **15.10.1997**
(21) Application number: 97302164.5
(22) Date of filing: 27.03.1997
(51) Int. Cl.: H01J 37/34

(54) **Plasma processing chamber with epicyclic magnet source assembly**

(30) Priority: 10.04.1996 US 630219
(71) Applicant: APPLIED MATERIALS, INC., Santa Clara, California 95054-3299 (US)
(72) Inventor: Huo, David Datong, Campbell, California 95008 (US)
(74) Representative: Bayliss, Geoffrey Cyril

(57) **Abstract**

A magnetron source (14) for use with a target (16) in a sputtering chamber (12), the magnetron source including a first shaft (92) having a first axis (112); a second shaft (80) having a second axis (110) that is parallel to and offset from the first axis; a magnet (70) assembly (22) mounted on the second shaft (80); and a gear assembly (70) which in response to rotation of the first shaft causes the second shaft to rotate and causes the magnet assembly to rotate about the second axis while the second axis rotates around the first axis, wherein during operation the magnet assembly sweeps over an area having a maximum dimension relative to the first axis of Rₘₐₓ, wherein the magnet assembly has a maximum effective radial dimension relative to second axis of rₘₐₓ, and wherein rₘₐₓ > 0.5 Rₘₐₓ.

## Description

The invention relates generally to sputtering deposition systems and to a planar magnetron source in a plasma processing chamber, such as is used to process semiconductor wafers and other substrates.

In general in a sputtering deposition system, high energy particles bombard a target so as to eject material from the target onto a vorkpiece, e.g. a semiconductor wafer. In physical sputtering, the bombarding particles are generally ions of a heavy inert gas such as argon which are accelerated to high velocities in directions that are substantially perpendicular to the face of the target. Plasma sputter deposition systems typically include a platform within a vacuum chamber that supports the wafer next to the face of the target. A voltage supply biases the target negatively relative to the wafer and this bias voltage produces an electric field across a plasma sheath that is formed next to the target. The electric field across the plasma sheath is substantially perpendicular to the face of the target. The ion densities which are created within the plasma sheath determine the rate of sputtering that is achievable. In a planar magnetron sputtering system, the ion densities at the target are further enhanced by producing within the plasma sheath next to the target a magnetic field that helps trap electrons near the target so that they may be directed into the target by the electric field. The magnetic field at the face of the target is usually generated by magnets that are placed behind the target.

To produce superior coating uniformity, step coverage and step coverage uniformity on the wafers that are being processed, magnetron assemblies have been designed that sputter or erode the target in a particular manner. Two such designs are described in greater detail in U.S. 5,320,728, entitled "Planar Magnetron Sputtering Source Producing Improved Coating Thickness Uniformity, Step Coverage and Step Coverage Uniformity", issued June 14, 1994; and in U.S. 5,242,566, entitled "Planar Magnetron Sputtering Source Enabling a Controlled Sputtering Profile Out to the Target Perimeter," issued September 7, 1993, both of which are assigned to the assignee of the present invention and both of which are incorporated herein by reference. The magnet assemblies within those described magnetron sources are rotated to produce the desired erosion patterns that produce higher quality deposited layers on the wafers. In general, such magnetron sources cause the target to erode in a manner which produces multiple grooves in the target. Though the nonuniform target erosion produces superior deposited layers, it has associated with it at least two significant disadvantages, namely, shorter target life and wasted target material. The target must be replaced before the erosion grooves penetrate the target and the backing plate becomes exposed to the sputtering plasma. Sputtering the backing plate will contaminate the plasma process and destroy product. However, when the target needs to be replaced, there is still considerable nonsputtered target material left in those areas outside of the grooves. Since target material can be very expensive, this waste can be quite costly. Therefore, it is desirable to design a magnetron source which still yields the advantages of these earlier designs but also produces extended target life as well as more effective use of the target.

In general, in one aspect the invention is a magnetron source for use with a target in a sputtering chamber. The magnetron source includes a first shaft having a first axis; a second shaft having a second axis that is parallel to and offset from the first axis; a magnet assembly mounted on the second shaft; and a gear assembly which in response to rotation of the first shaft causes the second shaft to rotate and causes the magnet assembly to rotate about the second axis while the second axis rotates around the first axis, so that the magnet assembly sweeps over an area having a maximum dimension relative to the first axis of Rₘₐₓ. Also, the magnet assembly has a maximum effective radial dimension relative the second axis of rₘₐₓ, and rₘₐₓ > 0.5 Rₘₐₓ.

In preferred embodiments, rₘₐₓ > 0.9 Rₘₐₓ. Also, the gear assembly is characterized by a gear ratio which is such that the second axis rotates around the first axis at a faster rate than the magnet assembly rotates about the second axis. In addition, the magnetron source also includes a housing which defines an internal cavity containing the magnet assembly, the first and second shafts, and the gear assembly. The housing includes an inlet port and an outlet port through which a coolant is circulated through the internal cavity during operation. The gear assembly is made up of a ring gear; and an epicyclic gear located inside of and engaging the ring gear, with the second shaft coupled to the epicyclic gear. The gear assembly also includes an arm coupled to the first shaft and having a third shaft coupled thereto. The third shaft has an axis that is parallel to and offset from the first shaft, and the epicyclic gear is rotatably mounted on the third shaft. The first and third shafts are axially aligned with each other. The arm includes a counterweight located on a side of the first shaft that is opposite from the third shaft. The gear has gear teeth on an inner perimeter and the epicyclic gear has gear teeth on its outer perimeter which engage the gear teeth of the ring gear. The housing also includes a backer plate for holding a target and there is a target mounted on the backer plate. Also, the magnet assembly includes an inner pole piece, an outer pole piece, and a plurality of magnets each having first and second pole faces, one of which is coupled to the first pole piece and the other of which is coupled to the second pole piece.

In general, in another aspect, the invention is a magnetron source for use with a target in a sputtering chamber. The magnetron source includes a first shaft having a first axis; a second shaft having a second axis that is parallel to and offset from the first axis; a magnet assembly mounted on the second shaft and having a maximum radial dimension relative the second axis of rₘₐₓ; and a gear assembly which in response to rotation of the first shaft causes the second shaft to rotate and causes the magnet assembly to rotate about the second axis while the second axis rotates around the first axis. Also, the offset is less than rₘₐₓ.

In preferred embodiments, the offset is substantially less than rₘₐₓ.

In general, in yet another aspect, the invention is a plasma processing system for sputtering material onto a substrate. The system includes a chamber body defining a processing cavity; a pedestal located within the processing cavity which holds the substrate during processing; and a magnetron source. The magnetron source is as described above.

The invention results in more effective use of sputtering targets. This is in part achieved by increasing the width of the erosion grooves that are produced in the target as compared to systems which only rotate the magnet about a fixed central axis.

Other advantages and features will become apparent from the following description of the preferred embodiment with reference to the accompanying drawings, in which:
Fig. 1 shows a plasma processing chamber with a magnetron source assembly;
Fig. 2 is a cross-sectional view of the magnetron source assembly shown in Fig. 1;
Fig. 2A is a more detailed view of the bearing assembly of Fig. 2, which mounts the epicyclic gear onto the spindle;
Fig. 3 is a top view of the magnetron source assembly shown in Fig. 1; and
Fig. 4 illustrates the movement of a point on the outer a perimeter of the magnet assembly.

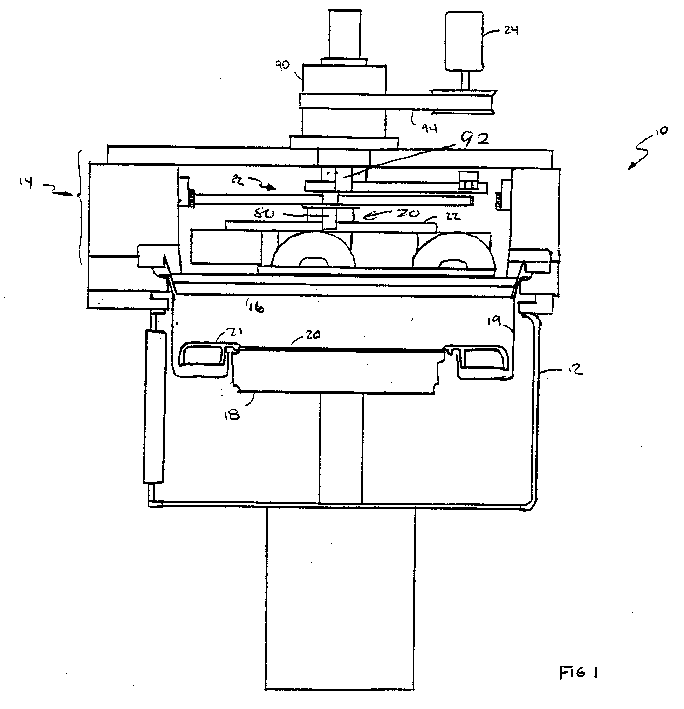

Referring to Fig. 1, a sputter deposition system 10 which incorporates the invention includes a vacuum chamber 12 with a planar magnetron source 14, a sputter target 16 which is attached to the magnetron source, and a pedestal 18 for holding a substrate 20 (e.g. semiconductor wafer) onto which material that is sputtered from target 16 is to be deposited. Target 16 is made of whatever material is to be deposited onto the substrate. For example, it could be aluminum if an aluminum metalization layer is to be deposited, it could be titanium or titanium nitride if a contact or barrier layer is to be deposited onto the bottoms of contact holes, or it could be tungsten, just to name a few possibilities.

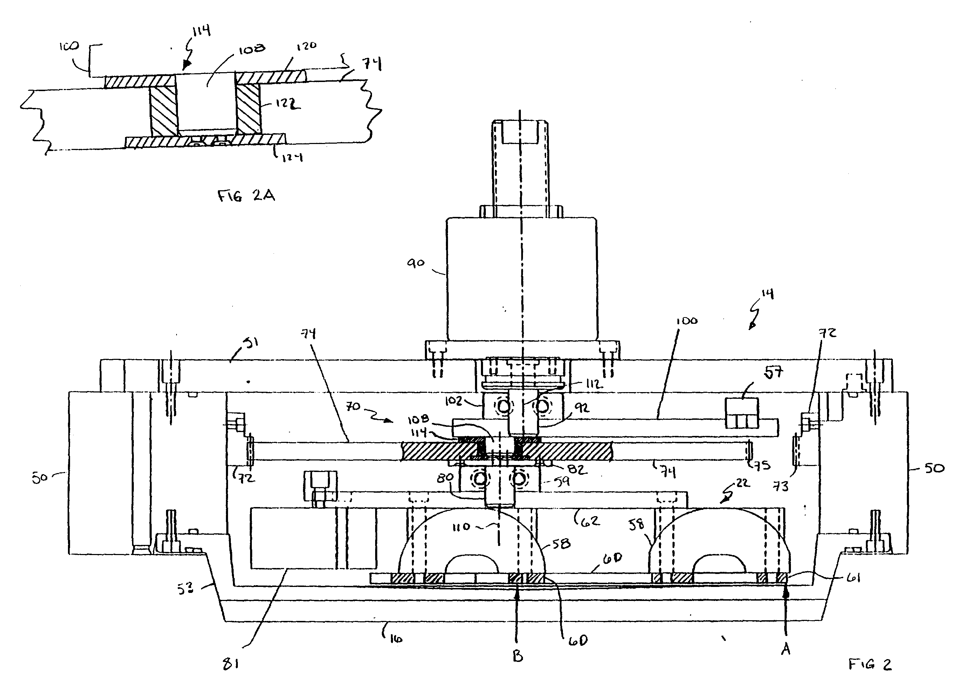

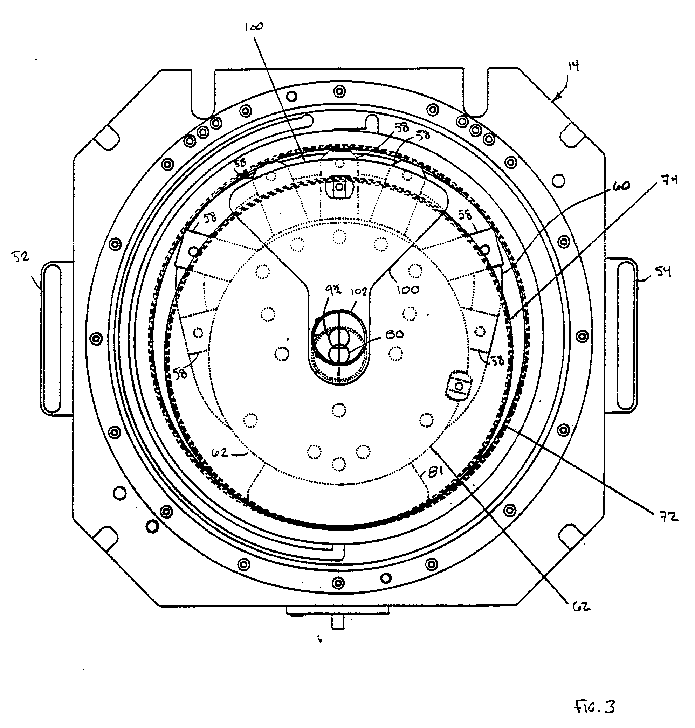

Magnetron source 14 includes a rotatable magnet assembly 22 which is located behind the target and which is positioned so as to produce a magnetic field that is substantially parallel to the surface of the target at a short distance in front of the target (e.g. 1-3 mm). A drive unit 24 (e.g. motor) wnich is connected through a coupling mechanism 26 to magnet assembly 22 rotates the magnet assembly in a plane that is parallel to and behind the target. Magnetron source 14, the design of which is shown in greater detail in Figs. 2 and 3, is constructed so that magnet assembly 22 performs epicyclic motion about a central axis of rotation.

Referring to Figs. 2 and 3, magnetron source 14 includes a source adapter which encloses the magnet assembly in a cavity through which coolant (e.g. water) is flowed during operation. The source adapter includes a housing 50 that is covered on its top end by a top plate 51 and on its bottom side by a backer plate 53 to which the target material is attached, e.g. bonded or fused. Inlet and outlet ports 52 and 54 through which coolant is flowed through the inside of source adapter are shown in Fig. 3. In the described embodiment, the magnet assembly is a kidney shaped configuration of multiple magnets 58 that are sandwiched between two pole pieces 60 and 61 on the bottom and a upper circular plate 62 on the top. Magnet assembly 22 is held together by screws which pass through the upper plate, through holes in the individual magnets, and screw into the pole piece to thereby clamp the assembly together.

In the described embodiment, there is an inner pole piece 60 and an outer pole piece 61. The south poles of the magnets are coupled to inner pole piece 60 and the north poles of the magnets are coupled to outer pole piece 61. The bottom surface of the pole pieces are about 1-3 mm from the back surface of backer plate 53. Near the center of the backer plate, the backside as a shallow and gradually sloped indentation (e.g. 1-2 mm deep) so as to improve circulation of coolant through between the pole pieces and the backside of backer plate 53. Also, since the weight of the magnets is offset from the axis of rotation of the magnet assembly, a counterweight 31 is attached to plate 62 so as to counterbalance the magnets.

The design of such magnets are known to persons skilled in the art and thus further details are not be provide here. Examples of magnet assemblies that can be used in the present embodiment are described in U.S. 5,320,723 and U.S. 5,242,566 and such magnets are also found on commercially available equipment such as that sold by Applied Materials, Inc. of Santa Clara, CA. (e.g. the Endura 5500^{TM} or the Cantura^{TM} systems). In the described embodiment, the magnets are Arnaco 5 magnets, which are well known commercially available magnets.

The movement of the magnet assembly is controlled by a gear arrangement 70 including an outer ring gear 72 and an inner gear 74 (referred to herein as an epicyclic gear 74) which is mounted inside of ring gear 72. Ring gear 72 is securely mounted onto source adapter housing 50 and has gear teeth 73 around its inside perimeter. Epicyclic gear 74 is a circular gear which has gear teeth 75 around its outer perimeter and which has a diameter that is smaller than the inside diameter of ring gear 72.

A clamp 59 which is mounted on to plate 62 of magnet assembly 22 clamps the magnet assembly onto a shaft 80 which is attached to epicyclic gear 74 and which has its axis aligned with the center of the axis of the epicyclic gear. Shaft 30 has a flange 82 at its uppermost end and this flange is screwed into the bottom side of epicyclic gear 74.

A feedthrough 90 mounted on top of top plate 51 of the magnetron source assemnly includes a bearing-mounted, rotatable shaft 92 which extends into the cavity within source adapter housing 50. Feedthrough 90 is driven by a belt 94 (see Fig. 1) that is connected between feedthrough 90 and the output shaft of drive motor 24. The feedthrough contains internal seals (not shown), which enable the rotation to be transmitted into the source adapter housing while still maintaining a seal between the inside of source adapter housing and the outside so that coolant within the source adapter housing does not leak out.

On the inside of source adapter housing, a counterweighted arm 100 is mounted onto drive shaft 92 by means of a clamp 102 that is attached to the top side of arm 100. Thus, arm 100 rotates with drive shaft 92. A spindle 108 that is attached to the bottom side of arm 100 has an axis 110 that is parallel to but offset from the axis of rotation 112 of drive shaft 92 so that when the drive shaft rotates, the spindle revolves around the axis of the drive shaft. A counterweight is integrally formed as part of the arm and extending away from spindle 108 and on the other side of axis 112 from spindle 108. The counterweight counterbalances the weight of the spindle 108 and the rest of the gearing mechanism to which spindle 108 is coupled.

On the top side of counterweighted arm 100 and near the perimeter of the counterweight portion, there is a sensor magnet 57. A detector (not shown) above top plate 51 senses the magnetic field that is produced by this sensor magnet and this provides an indication of both the rotation of the gearing mechanism and the rate of that rotation.

Epicyclic gear 74 is mounted onto spindle 108 by means of a bearing assembly 114 (which is shown in greater detail in Fig. 2A). Bearing assembly 114 includes an upper thrust plate 120, a bushing 122, and a lower retainer ring 124 which is screwed into the bottom of spindle 108. Retainer ring 124 has a diameter that is larger than the outside diameter of bushing 122. Epicyclic gear 74 has a hole located at its center which accommodates bearing assembly 114. An upper portion of the hole has a diameter that is slightly larger than the outer diameter of the bushing; and a lower portion of the hole has a diameter that is larger that the outside diameter of the retainer ring. When epicyclic gear 74 and bearing assembly 114 are assembled onto spindle 108, bushing 122 fits within the upper portion of the hole and retainer ring 124 fits within the lower portion of the hole. When retainer ring 124 is screwed into the bottom of spindle 108, it holds the epicyclic gear onto the spindle. The bearing components are made of a common bushing material such as bronze, brass, or copper.

The offset between the axes of rotation of drive shaft 92 and spindle 108 is such that the gear teeth of epicyclic gear 74 engage with the inside gear teeth of ring gear 72. When drive shaft 92 is rotated in clockwise direction by the motor, the axis of spindle 108 (indeed, the entire spindle) rotates in a clockwise direction around the axis of drive shaft 92. This causes epicyclic gear 74 to move around the inside perimeter of ring gear 72 and as it does this, it rotates in a counterclockwise direction.

In the described embodiment, the gearing ratio of the ring gear to the epicyclic gear is 5:4. Thus, when drive shaft 92 is rotated at 100 RPM, epicyclic gear 74 and the attached magnet assembly 22 rotates about the axis of spindle 108 at 20 RPM. The gear ratio can, of course, be different from that used in the described embodiment. The choice is in part determined by the process that is being performed in the chamber.

The motion of the magnet assembly can be visualized in the following way. For purposes of this description, it is worth noting that the magnet assembly has a maximum radial dimension Rₘₐₓ (i.e., the distance from its axis as defined by spindle 108 to its outermost extent). During operation, the axis of the magnet assembly rotates around the drive shaft axis magnet assembly in an orbit having a radius that is smaller (e.g. much smaller) than Rₘₐₓ. While the axis of the magnet assembly is performing this orbital motion, the magnet assembly Itself is rotating in a counterclockwise direction around its axis at a much slower rate (i.e., a rate that is determined by the gearing ratio).

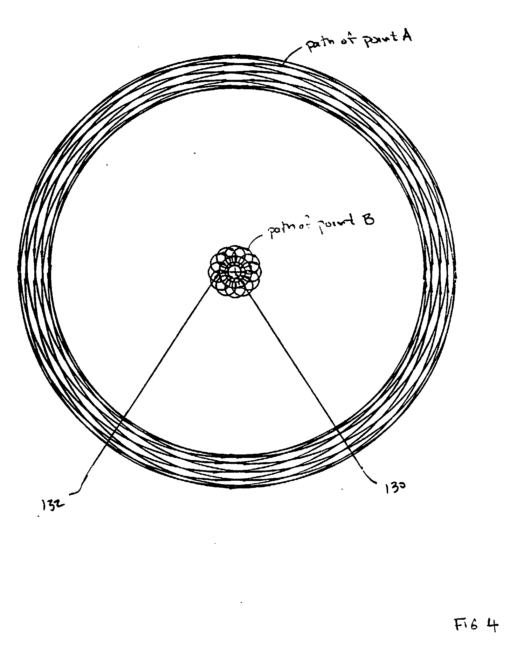

Fig. 4 shows the paths that are followed by two different points in the magnet assembly: one point "A" located on the outer edge of the magnet assembly and a second point "B" located as the magnets are rotated by drive motor 24 (also see Fig. 2). Center point 130 represents axis 112, i.e., the axis of the drive shaft which located at the center of the target. And circle 132 represents the path followed by axis 110 as the drive shaft rotates. The epicyclic motion of the magnet assembly has the effect of "dithering" the magnetic field. That is, it spreads out the width of the region of the target that is affected by the magnetic field produced by any particular point on the magnet. As should be apparent from Fig. 4, this will have the effect of broadening the sputtering grooves that are formed in the target during operation. Thus, more of the target material can be used before the target has to be replaced.

It is important to note that for the improved operation to be obtained, the offset should be less than (e.g., substantially less than) rₘₐₓ, and the magnet assembly should generally have an rₘₐₓ that is greater than one half the radius of the area that is swept out by the magnet assembly. Usually, the area that is swept out by the magnet assembly will be quite close to the actual area of the target itself. In the described embodiment, the offset is about 0.5 inch and rₘₐₓ is about 5.75 (i.e., 0.5 x 11.5) inches (for a system that processes 8 inch wafers). In this case, rₘₐₓ is actually greater than about 0.9 times the outer reach of the magnet assembly as it moves over the backside of the target. Also note that if the offset is larger than 0.5 rₘₐₓ, then the intense magnetic field produced by the magnet assembly will not pass over the center of the target and target erosion at the center will thus be considerably less than elsewhere. Of course, if the offset is zero and the spindle was attached directly to the drive shaft, that would be equivalent to the way in which the prior art systems are currently operated (i.e., simple rotation of the kidney-shaped magnet assembly).

When we refer to a radius or a maximum dimension of the magnet assembly, we mean this to be measured in terms of the reach of the magnetic field that it produces and not by the outside physical dimensions of the assembly. For example, the maximum effective radial dimension of the magnet assembly relative to a reference location (e.g. axis 110) is defined by the outer reach of the outermost magnetic pole pieces. Thus. referring to Fig. 2, the maximum radius in the cross-section that is illustrated is defined by the point labeled "A". This is true regardless of how much farther the support structure of the magnetic assembly might actually extend beyond that point. In other words, it is a measure of the outer reach of the magnetic field that passes through the pole pieces in the plane of the pole pieces. Also, It should be understood that when we refer to the area swept over by the magnet assembly, we mean an area that is substantially equal in shape and size to the area that is swept over by the pole faces of the magnet assembly.

In the described embodiment, the gears and the upper counterweight 100 are made of stainless steel. The lower counterweight 81 and the upper plate 62 are made of copper, or some other nonmagnetic material. Of course, this is not to suggest that other materials may not be used in other embodiments.

Referring again to Fig. 1, we note that there will typically be other components which make up a complete plasma deposition system. For example, around the outside perimeter of the target, there is generally a grounded metal shield 19 that extends down into the chamber and reaches below a clamping ring 21 which holds the wafer 20 during processing. This metal shield 19 protects the chamber walls from sputtered material.

The deposition system also typically includes other equipment which is not shown but which is well known in the art. For example, it includes a vacuum pump, which is used to evacuate the chamber to achieve the vacuum levels that are desired for sputtering, and it includes one or more sources of process gas (e.g. Argon), which are connected to the chamber through corresponding mass flow controllers. The mass flow controllers enable the user to precisely control the rate of flow or process gas into the chamber, thereby also controlling the total pressure in the chamber.

The system might also include a D.C. power supply which is connected between the target and the pedestal and which delivers the power that is necessary to generate a plasma during operation. The supply biases target negatively with respect to an electrically floating pedestal and the grounded chamber. In addition, there might also be coils or antennae mounted either inside and/or outside of the chamber for coupling energy from an RF source into the plasma that is generated in the chamber.

Also, in the described system, a programmable control unit (not shown) controls the overall operation of the system, including the operation of mass flow controllers, drive motor 24, the power supplies, and the vacuum pump. That is, it is programmed to fully automate the deposition and cleaning processes which are performed in the system.

Other embodiments are within the following claims.

## Claims

1. A magnetron source for use with a target in a sputtering chamber, said magnetron source comprising:
a first shaft having a first axis;
a second shaft having a second axis that is parallel to and offset from the first axis;
a magnet assembly mounted on the second shaft; and
a gear assembly which in response to rotation of the first shaft causes the second shaft to rotate and causes said magnet assembly to rotate about the second axis while the second axis rotates around the first axis, wherein during operation said magnet assembly sweeps over an area having a maximum dimension relative to the first axis of Rₘₐₓ wherein said magnet assembly has a maximum effective radial dimension relative the second axis of rₘₐₓ, and wherein rₘₐₓ > 0.5 Rₘₐₓ.

2. The magnetron source of claim 1 wherein rₘₐₓ > 0.9 Rₘₐₓ.

3. The magnetron source of claim 1 wherein the gear assembly is characterized by a gear ratio which is such that the second axis rotates around the first axis at a faster rate than the magnet assembly rotates about the second axis.

4. The magnetron source of claim 1 further comprising a housing which defines an internal cavity containing the magnet assembly, the first and second shafts, and the gear assembly.

5. The magnetron source of claim 4 wherein said housing includes an inlet port and an outlet port through which a coolant is circulated through the internal cavity during operation.

6. The magnetron source of claim 1 wherein said gear assembly comprises:
a ring gear; and
an epicyclic gear located inside of and engaging said ring gear, wherein said second shaft is coupled to said epicyclic gear.

7. The magnetron source of claim 6 wherein said gear assembly further comprises an arm coupled to the first shaft and having a third shaft coupled thereto, said third shaft having an axis that is parallel to and offset from said first shaft, wherein said epicyclic gear is rotatably mounted on said third shaft.

8. The magnetron source of claim 7 wherein said first and third shafts are axially aligned with each other.

9. The magnetron source of claim 8 wherein said arm includes a counterweight located on a side of the first shaft that is opposite from the third shaft.

10. The magnetron source of claim 7 wherein said ring gear has gear teeth on an inner perimeter and said epicyclic gear has gear teeth on its outer perimeter which engage the gear teeth of said ring gear.

11. The magnetron source of claim 10 wherein said housing further comprises a backer plate for holding a target.

12. The magnetron source of claim 11 further comprising a target mounted on the backer plate.

13. The magnetron source of claim 1 wherein said magnet assembly comprises an inner pole piece, an outer pole piece, and a plurality of magnets each having first and second pole faces, one of which is coupled to the first pole piece and the other of which is coupled to the second pole piece.

14. A magnetron source for use with a target in a sputtering chamber, said magnetron source comprising:
a first shaft having a first axis;
a second shaft having a second axis that is parallel to and offset from the first axis;
a magnet assembly mounted on the second shaft, wherein said magnet assembly has a maximum radial dimension relative the second axis of rₘₐₓ, and wherein said offset is less than rₘₐₓ; and
a gear assembly which in response to rotation of the first shaft causes the second shaft to rotate and causes said magnet assembly to rotate about the second axis while the second axis rotates around the first axis.

15. The magnetron source of claim 14 wherein said offset is substantially less than rₘₐₓ.

16. A plasma processing system for sputtering material onto a substrate, said system comprising:
a chamber body defining a processing cavity;
a pedestal which holds the substrate during processing, said pedestal located within said processing cavity; and
a magnetron source comprising:
a first shaft having a first axis;
a second shaft having a second axis that is parallel to and offset from the first axis;
a magnet assembly mounted on the second shaft; and
a gear assembly which in response to rotation of the first shaft causes the second shaft to rotate and causes said magnet assembly to rotate about the second axis while the second axis rotates around the first axis, wherein during operation said magnet assembly sweeps over an area having a maximum dimension relative to the first axis of Rₘₐₓ, wherein said magnet assembly has a maximum effective radial dimension relative the second axis of rₘₐₓ, and wherein rₘₐₓ > 0.5 Rₘₐₓ.

17. The magnetron source of claim 16 wherein rₘₐₓ > 0.9 Rₘₐₓ.

18. The magnetron source of claim 16 wherein the gear assembly is characterized by a gear ratio which is such that the second axis rotates around the first axis at a faster rate than the magnet assembly rotates about the second axis.

19. The magnetron source of claim 16 further comprising a housing which defines an internal cavity containing the magnet assembly, the first and second shafts, and the gear assembly.

20. The magnetron source of claim 19 wherein said housing includes an inlet port and an outlet port through which a coolant is circulated through the internal cavity during operation.

21. The magnetron source of claim 16 wherein said gear assembly comprises:
a ring gear; and
an epicyclic gear located inside of and engaging said ring gear, wherein said second shaft is coupled to said epicyclic gear.

22. The magnetron source of claim 21 wherein said gear assembly further comprises an arm coupled to the first shaft and having a third shaft coupled thereto, said third shaft having an axis that is parallel to and offset from said first shaft, wherein said epicyclic gear is rotatably mounted on said third shaft.

23. The magnetron source of claim 22 wherein said first and third shafts are axially aligned with each other.

24. The magnetron source of claim 23 wherein said arm includes a counterweight located on a side of the first shaft that is opposite from the third shaft.

25. The magnetron source of claim 24 wherein said ring gear has gear teeth on an inner perimeter and said epicyclic gear has gear teeth on its outer perimeter which engage the gear teeth of said ring gear.

26. The magnetron source of claim 25 wherein said housing further comprises a backer plate for holding a target.

27. The magnetron source of claim 26 further comprising a target mounted on the backer plate.

28. The magnetron source of claim 16 wherein said magnet assembly comprises an inner pole piece, an outer pole piece, and a plurality of magnets each having first and second pole faces, one of which is coupled to the first pole piece and the other of which is coupled to the second pole piece.
